(19) Europäisches Patentamt
European Patent Office
Office européen des brevets

(11) **EP 1 817 792 B1**

(12) **EUROPÄISCHE PATENTSCHRIFT**

(45) Veröffentlichungstag und Bekanntmachung des Hinweises auf die Patenterteilung:
**27.07.2016 Patentblatt 2016/30**

(21) Anmeldenummer: **05802410.0**

(22) Anmeldetag: **03.11.2005**

(51) Int Cl.:
***H01L 21/266*** (2006.01)

(86) Internationale Anmeldenummer:
**PCT/EP2005/011774**

(87) Internationale Veröffentlichungsnummer:
**WO 2006/058594 (08.06.2006 Gazette 2006/23)**

(54) **MEHRFACHMASKE UND VERFAHREN ZUR HERSTELLUNG UNTERSCHIEDLICH DOTIERTER GEBIETE**

MULTIPLE MASK AND METHOD FOR PRODUCING DIFFERENTLY DOPED REGIONS

MASQUE MULTIPLE ET PROCEDE POUR PRODUIRE DES REGIONS A DOPAGE DIFFERENT

(84) Benannte Vertragsstaaten:
**FR GB**

(30) Priorität: **03.12.2004 DE 102004058412**

(43) Veröffentlichungstag der Anmeldung:
**15.08.2007 Patentblatt 2007/33**

(73) Patentinhaber: **ams AG**
**8141 Unterpremstätten (AT)**

(72) Erfinder:
• **KNAIPP, Martin**
**A-8141 Unterpremstätten (AT)**
• **MINIXHOFER, Rainer**
**A-8141 Unterpremstätten (AT)**
• **SCHREMS, Martin**
**A-8063 Eggersdorf (AT)**

(74) Vertreter: **Epping - Hermann - Fischer**
**Patentanwaltsgesellschaft mbH**
**Schloßschmidstraße 5**
**80639 München (DE)**

(56) Entgegenhaltungen:
**WO-A-95/29505        JP-A- H0 955 438**
**JP-A- H0 963 983      JP-A- 2000 228 496**
**US-A- 4 648 174        US-A1- 2004 164 379**

• **PATENT ABSTRACTS OF JAPAN Bd. 1999, Nr. 12, 29. Oktober 1999 (1999-10-29) & JP 11 204543 A (MITSUBISHI ELECTRIC CORP), 30. Juli 1999 (1999-07-30)**

EP 1 817 792 B1

## Beschreibung

Mehrfachmaske und Verfahren zur Herstellung unterschiedlich dotierter Gebiete.

Zur Herstellung von Dotierungen insbesondere in Halbleitermaterialien sind Implantationsverfahren geeignet, bei denen die Implantationstiefe beispielsweise durch die kinetische Energie der zu implantierenden beispielsweise ionischen Dotierstoffe bestimmt wird. Alternativ und gegebenenfalls zusätzlich ist es möglich, einen implantierten Dotierstoff durch Einstellen geeigneter Eintreibbedingungen, insbesondere durch Fahren eines geeigneten Temperaturprogramms weiter in das Halbleitermaterial eindiffundieren zu lassen. Durch genaue Abstimmung von Implantationsverfahren und Eintreibbedingungen können auf diese Art und Weise unterschiedliche Dotierprofile hergestellt werden. Eine weitere bekannte Möglichkeit, die Implantationstiefe zu kontrollieren, besteht in der Kontrolle der Menge des implantierten Dotierstoffs.

Bei elektronischen Bauelementen, die für einen Hochvolteinsatz bei beispielsweise 50V geeignet sind, ist die Einstellung optimaler Dotierprofile besonders wichtig, da unter dem Einfluß der hohen am Bauelement anliegenden Spannung besonders leicht elektrische Kurzschlüsse z.B. zum Substrat oder zu anderen Bauelementstrukturen hin auftreten können. Ein solches ungeeignetes Dotierprofil kann außerdem ebenfalls unerwünschte Ströme, z.B. aufgrund von Stoßionisation verursachen.

Zur elektrischen Isolierung von Transistorkontakten, insbesondere bei Hochvoltbauelementen, werden üblicherweise ineinander angeordnete Wannen mit entgegengesetzter Leitfähigkeit eingesetzt, so daß an den Übergängen des mit einem Dotierstoff eines ersten Leitfähigkeitstyps dotierten Anschlußgebiets zur äußeren isolierenden Wanne, die mit einem Dotierstoff eines zweiten Leitfähigkeitstyps dotiert ist, sowie am Übergang von der isolierenden Wanne hin zum Substrat, welches wiederum mit einem Dotierstoff des ersten Leitfähigkeitstyps dotiert ist, zusätzliche Raumladungszonen entstehen, die Ladungsträgerbarrieren darstellen.

Zur Herstellung von unterschiedlichen tiefen Dotierungen nebeneinander in einem Substrat werden bislang mehrere Dotierungsschritte mit unterschiedlichen Dotierungsmasken verwendet, um entweder eine unterschiedliche Implantationsdosis oder ein für die Dotierungsschritte unterschiedliches thermisches Budget zum Eintreiben des implantierten Dotierstoffs einsetzen zu können. Dies erfordert bezüglich der notwendigen zusätzlichen Dotierungsmasken und der damit verbundenen zusätzlichen Verfahrensschritte einen erhöhten Aufwand gegenüber der Herstellung eines Dotierungsgebiets mit einheitlicher Dotierungstiefe.

Auch zur Herstellung von Dotierungen unterschiedlichen Typs nebeneinander in einem Substrat werden bislang üblicherweise mehrere Dotierungsschritte mit unterschiedlichen Dotierungsmasken verwendet.

Aus der US 5,300,545 A ist ein Verfahren bekannt, das unterschiedlich starke Dotierungen des gleichen Typs in unterschiedlichen Gebieten in einem einzigen Schritt erzeugen kann. Dazu wird eine Maske erzeugt, die Gebiete mit unterschiedlichen geometrischen Features aufweist. Die unterschiedlichen Gebiete in der Maske unterscheiden sich durch unterschiedliche Dichte von Maskenöffnungen. Die damit erzielbare Dotierungsstärke ist eine Funktion der Dichte der Maskenöffnungen.

Aus der US 5,512,498 A ist ein Verfahren bekannt, mit dem in zwei unterschiedlichen Gebieten zwei unterschiedliche Dotierungen in zwei Hauptschritten, aber mit der gleichen Maske erzeugt werden können. Zunächst wird eine Schrägimplantation unter einem ersten Winkel auf ein rotierendes Substrat durchgeführt. Danach erfolgt eine im Wesentlichen vertikale Implantation. Im ersten Gebiet weisen die Maskenöffnungen ein so geringes Aspektverhältnis auf, dass die Dotierstoffe bei der Schrägimplantation das Substrat nicht erreichen. Beim zweiten Dotierungshauptschritt wird nicht zwischen erstem und zweiten Gebiet unterschieden. Mit diesem Verfahren gelingt es jedoch nicht, zwei entgegengesetzte Dotierungen mit der gleichen Maske zu erzeugen.

JP 09 055438 A beschreibt die Verwendung von Masken mit zwei Gruppen streifenförmiger paralleler Öffnungen, wobei die Längsrichtung der Öffnungen der einen Gruppe im 90°-Winkel zu der Längsrichtung der Öffnungen der anderen Gruppe verläuft. Schräge Implantationen unterschiedlicher Dotierstoffe und Richtungen nutzen die abschattende Wirkung jeweils einer Gruppe von Maskenöffnungen.

JP 2000 228496 A beschreibt die schräge Implantation unterschiedlicher Dotierstoffe in streifenförmige parallele Stege, wobei das Substrat zwischen den Implantationen um 90° gedreht wird. Auch hier wird die abschattende Wirkung der quer zu der Implantationsrichtung verlaufenden Stege ausgenutzt.

JP09063983 A beschreibt eine Maske zum Erzeugen unterschiedlicher Dotierungen. Die Maske besitzt mehre streifenförmige parallele Stege, die jeweils um 90° zueinander ausgerichtet sind. Zur Herstellung unterschiedlicher Dotierungen weisen die Stege unterschiedlich bereite Abstände auf.

US4648174 A schlägt zu diesem Zweck eine Maske vor, die mehrere Bereiche mit Strukturen unterschiedlicher Geometrie aufweist.

Aufgabe der vorliegenden Erfindung ist es, anzugeben, wie auf eine einfache Weise unterschiedliche Dotierungsgebiete in einem Substrat ausgebildet werden können.

Diese Aufgabe wird mit einer Maske mit den Merkmalen des Anspruches 1 beziehungsweise mit dem Verfahren mit den Merkmalen des Anspruches 9 gelöst. Ausgestaltungen der Erfindung gehen aus den abhängigen Ansprüchen hervor.

Der Erfindung liegt die Idee zugrunde, für Implantationen eine auf einem Substrat aufliegende Maske zu schaffen, die zumindest drei Maskenbereiche aufweist, wobei sich erster, zweiter und dritter Maskenbereich dadurch unterscheiden, dass sie gegenüber Implantationsschritten, die aus unterschiedlichen Raumrichtungen durchgeführt werden, ein unterschiedliches Abschattungsverhalten aufweisen.

Unterschiedliches Abschattungsverhalten wird mit langgestreckten Maskenöffnungen erreicht, wobei erste Maskenöffnungen innerhalb des ersten Maskenbereichs parallel zu einer ersten Ausrichtung und zweite Maskenöffnungen innerhalb des zweiten Maskenbereichs parallel zu einer zweiten Ausrichtung ausgerichtet sind, wobei erste und zweite Ausrichtung einen von Null verschiedenen Winkel β < 90° gegeneinander einschließen. Auf diese Weise ist es möglich, bei einer ersten Schrägimplantation aus einer Raumrichtung parallel zur ersten Ausrichtung im ersten Maskenbereich eine minimale Abschattung gegenüber der Implantation durchzuführen, im zweiten Maskenbereich eine demgegenüber höhere Abschattung. Anschließend kann das Substrat um den Winkel β gedreht und eine zweite Schrägimplantation aus der gleichen Raumrichtung parallel zu den Maskenöffnungen des zweiten Maskenbereichs durchgeführt werden, wobei dann im zweiten Maskenbereich eine minimale Abschattung, im ersten dagegen eine höhere Abschattung erzielt wird. Alternativ zum Drehen des Substrats kann natürlich auch die zweite Schrägimplantation aus einer um den Winkel β verschiedener Raumrichtung durchgeführt werden.

Die mit der Maske erzielbare Abschattung ist abhängig vom Aspektverhältnis der Maskenöffnungen in der Maskenschicht sowie vom Einfallwinkel α der bei der Implantation in das Substrat eingebrachten Dotierstoffionen und -atome, der gegen eine senkrecht auf dem Substrat stehende Normale bemessen wird. Dabei ist es möglich, bei einer Schrägimplantation aus einer Raumrichtung quer zu der Ausrichtung der Maskenöffnungen das Aspektverhältnis in Abhängigkeit vom Implantationswinkel so zu wählen, dass der schräg implantierte Dotierstoff das Substrat innerhalb der Maskenöffnung nicht erreicht und vollständig von der Maske abgeschattet wird. Trifft dies auch für den anderen Maskenbereich bei der zweiten Implantation zu, so ist es möglich, zwei unterschiedliche, gegebenenfalls entgegengesetzte Dotierungen mit der gleichen Maske zu erzeugen. Es wird also pro Implantationsschritt in je einem Maskenbereich eine vollständige Abschattung erzeugt, sodass die beiden Implantationsschritte jeweils selektiv zu einer Dotierung des Substrat unterhalb des jeweiligen Maskenbereichs führen und sich dabei gegenseitig nicht stören.

Bei der Implantation werden Ionen implantiert, die im Halbleiter als Donatoren oder Akzeptoren wirken. Im Rahmen der Erfindung werden unter Dotierstoffen aber auch alle anderen Ionen verstanden, die sich implantieren lassen, um damit bestimmte Effekte im Halbleiter zu erzielen.

Es ist vorteilhaft, im ersten und zweiten Maskenbereich Maskenöffnungen jeweils gleicher Breite b vorzusehen. Dabei kann ein Maskenbereich mehrere in gleichem Abstand parallel zueinander angeordnete, gleichartige Maskenöffnungen aufweisen. Die Breite b der Maskenöffnungen und deren Abstand a zueinander wird so gewählt, dass unterhalb der Maskenöffnungen implantierte Gebiete entstehen, die nach einem Temperschritt zu einem einheitlichen dotierten Gebiet gewünschter Dotierstoffkonzentration zusammenwachsen können. Dies bedeutet, dass für flachere dotierte Gebiete für die Maskenöffnungen ein geringerer Abstand a gewählt wird, während für tiefere dotierte Gebiete dagegen ein größerer Abstand gewählt werden kann. Zum Erzielen einer maximalen Homogenität im dotierten Gebiet nach dem Eintreiben der implantierten Dotierung ist es jedoch vorteilhaft, den Abstand a der Maskenöffnungen minimal zu wählen, um Konzentrationsschwankungen des diffundierten Dotierstoffes zu vermeiden.

In der Erfindung ist ein dritter Maskenbereich mit dritten Maskenöffnungen vorgesehen, die langgestreckt und parallel zueinander entlang einer dritten Ausrichtung ausgebildet sind. Die Ausrichtung des dritten Maskenbereichs ist dabei so gewählt, dass sie gegebenenfalls unterschiedliche Winkel β gegen die Ausrichtungen der beiden anderen Maskenbereiche einschließt. Vorteilhaft ist es, bei gleichem a und b die Winkel β maximal zu wählen, sodass bei drei Maskenbereichen ein Winkel β von jeweils 60° zwischen zwei Ausrichtungen eingehalten wird.

Bei gegebenem Implantationswinkel α und gegebener Breite b der Maskenöffnungen entspricht dies einer maximalen Abschattung in zweitem und drittem Maskenbereich, wenn parallel zur ersten Ausrichtung schrägimplantiert wird.

Die Maske selbst liegt auf dem Substrat auf und stellt beispielsweise eine strukturierte Resistschicht dar. Möglich ist es jedoch auch, für das Implantationsverfahren eine Hartmaske zu verwenden, die ebenfalls mit einer Fototechnik, also mit einer Resiststruktur strukturiert werden kann. Als Hartmaske geeignet sind beispielsweise Oxidmasken oder solche aus Siliziumnitrid. In Abhängigkeit von dem Material der Maskenschicht kann noch ein weiterer Parameter berücksichtigt werden, der die Eindringtiefe des Dotierstoffs bei der Implantation in die Oberfläche der Maskenstruktur und insbesondere in die Seitenwände der Maskenöffnungen berücksichtigt. Mit steigender Eindringtiefe des Dotierstoffs in die Maske ist das Aspektverhältnis entsprechend höher zu wählen oder alternativ der Implantationswinkel α zu erhöhen.

Ein optimaler Implantationswinkel liegt z.B. im Bereich von 45°, ist aber zusätzlich abhängig von der Dicke der Maskenschicht, der Implantationsenergie und der Auflösegenauigkeit der für die Maskenherstellung verwendeten Lithographie und kann daher davon abweichen. Bei unterschiedlichen Dotierstoffen (Dopanden) können auch unterschiedliche Implantationswinkel optimal sein. Bei einem Implantationswinkel von beispielsweise 45° wird eine vollständige Abschattung mit einer Maskenöffnung erzielt, deren Aspektverhältnis in Implantationsrichtung gemessen größer gleich 1 gewählt ist, bei dem also die Höhe h der Maskenschicht größer gleich der Breite b der Maskenöffnung ist. Vorteilhaft ist es, eine Toleranz gegen Streuungen an Kanten der Maskenöffnungen einzuhalten und die Tatsache zu berücksichtigen, dass die Maskenstärke insbesondere im unteren Bereich der Maskenöffnungen nicht mehr ausreichend ist, die Dotierstoffe bei der Schrägimplantation vollständig abzuschatten und somit vollständig vom Eindringen in das Substrat abzuhalten.

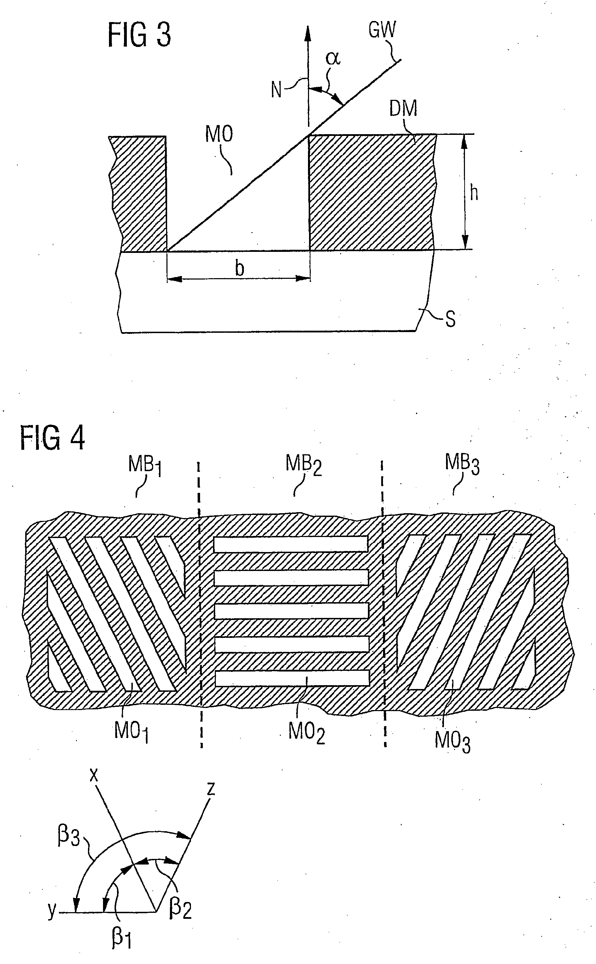

Im Querschnitt parallel zur Substratoberfläche sind die Maskenöffnungen vorzugsweise in Form langgestreckter Rechtecke ausgebildet. Möglich ist es jedoch auch, dass die Maskenöffnungen mit anderer Form und insbesondere als langgestreckte Parallelogramme, Trapeze oder mit abgerundeten Enden auszubilden. Ein Parallelogramm ist insbesondere dann von Vorteil, wenn die Maskenbereiche parallel zueinander ausgerichtete Rechtecke sind und der Winkel β zwischen den Ausrichtungen der Maskenöffnungen innerhalb zweier Maskenbereiche von 90° abweicht (siehe Figur 4). Solche Maskenbereiche können mit Maskenöffnungen nur dann vollständig ausgefüllt werden, wenn die Maskenöffnungen im Querschnitt parallel zum Substrat als Parallelogramme ausgebildet sind.

Mit der erfindungsgemäßen Maske ist es weiterhin möglich, nicht nur unterschiedliche Dotierungen in unterschiedlichen Maskenbereichen, sondern auch unterschiedliche Dotierstärken in unterschiedlichen Maskenbereichen zu erzeugen. Dies wird möglich, indem die "Dichte" der Maskenöffnungen in einem Maskenbereich erhöht oder erniedrigt wird. Dies gelingt durch eine entsprechende Veränderung des Abstands der Maskenöffnungen oder durch Variation der Breite b der Maskenöffnungen, jeweils relativ zum anderen Maskenbereich. Natürlich kann die Dotierungsstärke auch direkt über die Dauer der Implantation und so die Menge der implantierten Dotierstoffe eingestellt werden.

Ohne Berücksichtigung der Tatsache, dass ein gegebenes Maskenmaterial gegenüber der Implantation zu einem gewissen Grad bzw. bis zu einer gewissen Tiefe durchlässig ist, wird in einer Maskenöffnung ein direktes Auftreffen von Dotierstoff auf die am Boden der Maskenöffnungen freiliegende Substratoberfläche vermieden, wenn bei einer gegen die in die Ebene projizierte Implantationsrichtung um den Winkel β verdrehten Ausrichtung der Maskenöffnung die Höhe h mal dem Tangens des Implantationswinkels $\alpha \geq$ der Breite b durch den Cosinus von β ist. Damit wird erreicht, dass im ersten Maskenbereich bei einer ersten Implantation unter einem Implantationswinkel $a \geq \alpha_{min}$ ($\alpha_{min}$ = kleinster Winkel $\alpha$ mit vollständiger Abschattung) durch die Maske eine minimale Abschattung, im zweiten Maskenbereich, der um den Winkel β bezüglich seiner Ausrichtung gegenüber dem ersten verdreht ist, eine vollständige Abschattung gegen direkt auf das Substrat auftreffende Dotierstoffe erzielt wird.

Im Folgenden wird die Erfindung anhand von Ausführungsbeispielen und der dazugehörigen Figuren näher erläutert. Die Figuren dienen allein der Veranschaulichung der Erfindung, sind daher nur schematisch und nicht maßstabsgetreu ausgeführt. Gleiche oder gleich wirkende Teile sind mit gleichen Bezugszeichen bezeichnet.

Figur 1 zeigt einen ersten Maskenbereich mit langgestreckten Maskenöffnungen,

Figur 2 zeigt zwei Maskenbereiche mit unterschiedlicher Ausrichtung,

Figur 3 zeigt einen schematischen Querschnitt durch eine Maskenöffnung zur Verdeutlichung der Abschattung,

Figur 4 zeigt eine Dotierungsmaske mit drei Maskenbereichen,

Figur 5 zeigt die Winkel und Größenbeziehungen zweier Maskenöffnungen mit unterschiedlicher Ausrichtung,

Figur 6 zeigt anhand eines schematischen Querschnitts das Eintreibung einer implantierten Dotierung.

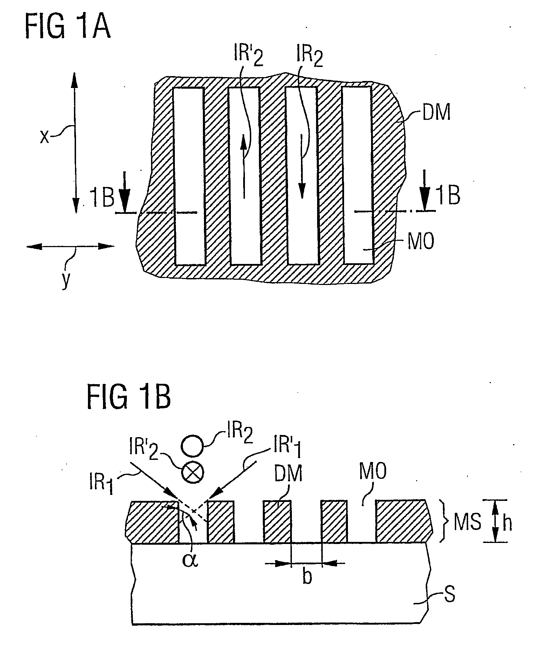

Figur 1 zeigt eine Dotierungsmaske DM mit langgestreckten Maskenöffnungen MO anhand einer schematischen Draufsicht (Figur 1A) und eines Querschnitts entlang der Schnittebene 1b (Figur 1B). Die Dotierungsmaske DM ist aus einer Maskenschicht strukturiert, die aus einem beliebigen strukturierbaren und insbesondere für die Implantation wenig oder undurchlässigem Material besteht. Geeignete Materialien zur Herstellung von Masken für Implantationszwecke sind beispielsweise Resistschichten oder auch Hartmasken aus beispielsweise Siliziumnitrid. Die Höhe h der Maskenschicht bzw. der daraus strukturierten Maske DM wird sowohl in Abhängigkeit von der Breite b der Maskenöffnung als auch von der Durchlässigkeit des Maskenmaterials gegenüber den implantierten Dotierstoffen bestimmt. Langgestreckte Maskenöffnungen MO, die parallel zur Achse x ausgerichtet sind, weisen gegenüber einer Schrägimplantation aus der Implantationsrichtung IR2, die in der Figur durch die in die Ebene projizierten Pfeile dargestellt ist, eine minimale Abschattung auf. Gegenüber einer Schrägimplantation, die parallel zur Achse y entlang der Implantationsrichtung IR1 durchgeführt wird, weist die dargestellte Maske DM dagegen eine maximale Abschattung auf. In Figur 1b ist die Implantation entlang der Implantationsrichtung IR1 unter einem Einfallswinkel $\alpha$, gemessen gegen die Normale, die senkrecht über der Oberfläche des Substrats S steht, dargestellt, die zu einer vollständigen Abschattung des Substrats S gegenüber der Implantation durch die Maske DM führt. Der Implantationswinkel $\alpha$ ist so bemessen, dass die entlang der Implantationsrichtung in Richtung Substrat beschleunigten Dotierstoffe ausschließlich auf die Seitenwände der Maske DM innerhalb der Maskenöffnungen MO auftreffen können.

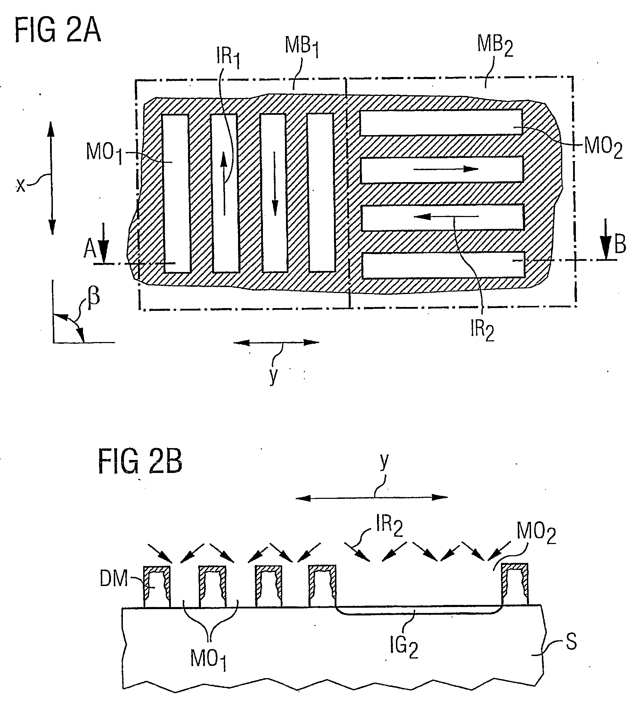

In Figur 2 ist eine Maske dargestellt, die sich dieses Abschattungsverhalten langgestreckter Maskenöffnungen zu Diensten macht. Die Maske umfasst einen ersten Maskenbereich MB1 mit ersten Maskenöffnungen MOlund einen zweiten Maskenbereich MB2 mit zweiten Maskenöffnungen MO2, die langgestreckt und parallel zu den Achsen x bzw. y ausgerichtet sind. Die Achsen x und y schließen gegeneinander einen Winkel β ein, vorzugsweise einen 90° Winkel. Die dargestellte Maske DM mit den zwei Maskenbereichen MB1, MB2 kann nun dazu verwendet werden, eine erste Implantation aus einer Implantationsrichtung IR1 durchzuführen, bei der die Maskenöffnungen MO1 des ersten Maskenbereichs MB1 eine minimale Abschattung aufweisen, während in den Maskenöffnungen MO2 des zweiten Maskenbereichs MB2 gegenüber dieser Implantation entlang der Implantationsrichtung IR1 eine maximale Abschattung erzielt wird. Bei entsprechender Wahl des Implantationswinkels α kann eine vollständige Abschattung im zweiten Maskenbereich MB2 erreicht werden, sodass bei dieser Implantation keinerlei Dotierstoff in das Substrat in den Maskenöffnungen MO2 gelangt, wohl aber innerhalb der ersten Maskenöffnungen MO1.

Figur 2b zeigt die Maske DM anhand eines schematischen Querschnitts entlang der Linie AB in Figur 2a. Dargestellt ist die Maske während oder nach einer Implantation entlang der Implantationsrichtung IR2, deren Projektion in die Substratebene parallel zur Achse y ausgerichtet ist. Aus Figur 2 ist klar zu erkennen, dass eine solche Implantation innerhalb der Maskenöffnungen MO2 zu einer Dotierung innerhalb des Substrats im Bereich der Maskenöffnung M02 führt. Dabei wird ein zweites implantiertes Gebiet IG2 erzeugt. Im ersten Maskenbereich MB1 mit den ersten Maskenöffnungen MO1 dagegen wird die Implantation durch die Dotiermaske DM vollständig abgeschattet. Die Dotierstoffe treffen dabei ausschließlich auf die Maske DM und dringen gegebenenfalls zu einer geringen Tiefe in deren Oberfläche ein, wie es in der Figur 2b durch die entsprechende Schattierung dargestellt ist. Auf diese Weise gelingt es, mit einer ersten Implantation parallel zur Achse x innerhalb des ersten Maskenbereichs eine erste Dotierung zu erzeugen, mit einer Implantation quer dazu entlang der Achse y in einem zweiten Maskenbereich eine Dotierung (siehe implantiertes Gebiet IG2) zu erzeugen, wobei das Substrat im zweiten Maskenbereich MB2 frei von Dotierstoffen aus der ersten Implantation, im ersten Maskenbereich dagegen frei von Dotierstoffen der zweiten Implantation bleibt.

Die selbe Maske kann daher für beide Implantationen dienen und muss dazwischen nicht entfernt werden.

Auf diese Weise können unterschiedlich dotierte Gebiete erzeugt werden, wobei beliebige Dotierungen unabhängig voneinander nebeneinander mit der gleichen Maske in unterschiedlichen Maskenbereichen erzeugt werden können. Gut geeignete Kombinationen sind z. B. eine n- und eine p-Dotierung, aber auch Sauerstoff- oder Stickstoffionen oder andere Ionen können implantiert werden. Möglich ist es auch, Dotierungen vom gleichen Leitfähigkeitstyp, aber mit unterschiedlichen Ionen mit Hilfe der erfindungsgemäßen Maske zu erzeugen. Beispielsweise können in den zwei Implantationsschritten Arsen und Phosphor in unterschiedlichen Maskenbereichen eingebracht und das Substrat in diesen Bereichen entsprechend dotiert werden. In einen dritten Maskenbereich könnte dann z.B. Bor implantiert werden.

In Figur 3 ist anhand eines schematischen Querschnitts quer durch eine Maskenöffnung dargelegt, wie die Maskenöffnung zu bemessen ist, damit bei einer Schrägimplantation unter dem Implantationswinkel α eine hundertprozentige Abschattung erfolgt. Wird die Implantation unter einem durch die Implantationsrichtung GW dargestellten Grenzwinkel durchgeführt, so findet gerade eben eine vollständige Abschattung durch die Maske DM statt, zumindest was das direkte Auftreffen von Dotierstoffen auf die Oberfläche des Substrats S innerhalb der Maskenöffnung MO betrifft. Für die Implantationsrichtung unter dem Grenzwinkel GW gilt, dass der Tangens des entsprechenden dazugehörigen Implantationswinkels α gleich dem Quotienten b/h aus der Breite und der Höhe der Maskenöffnung MO ist. Für Implantationswinkel, die kleiner sind als α, tritt keine vollständige Abschattung auf, wohl aber für Implantationen unter einem Implantationswinkel α > GW. Dies bedeutet, dass für eine vollständige Abschattung die Bemessung von h und b so zu führen ist, dass gilt:

$$\tan\alpha \geq b/h.$$

In Figur 4 ist eine erfindungsgemäße Maske DM in schematischer Draufsicht dargestellt, die drei Maskenbereiche MB1, MB2 und MB3 umfasst, die jeweils länggestreckte Maskenöffnungen MO aufweisen, die entlang der Achsen x, y und z ausgerichtet sind. Die Achse x schließt einen Winkel β1 zur Achse y und eine Winkel β2 zur Achse z ein. Der Winkel β3 bezeichnet den Winkel zwischen der Achse y und der Achse z. Mit einer solchen Maske ist es möglich, das erfindungsgemäße Prinzip zu verwirklichen. Jede Schrägimplantation, die parallel zur Ausrichtung der Maskenöffnung innerhalb eines Maskenbereiches geführt wird, führt dort zu einer minimalen Abschattung und daher zu einer maximalen Dotierung. In den verbleibenden Maskenbereichen dagegen, deren Ausrichtung um einen entsprechenden Winkel β verdreht ist, wird eine Abschattung gegenüber dieser Implantation erzielt. Obwohl β1 und β2 nicht beide gleichzeitig einen Wert von 90° annehmen können, wird auch mit geringeren Winkeln β zwischen den Ausrichtungen der Maskenöffnungen unterschiedlicher Maskenbereiche eine Abschattung erzielt, die durch entsprechende Bemessungen der Dimensionen der Maskenöffnungen MO eine hundertprozentige Abschattung sein kann.

Zum Einstellen gewisser Dotierstoffprofile kann es jedoch wünschenswert sein, dass sich die Dotierung mit einem Dotierstoff nicht ausschließlich auf einen Maskenbereich beschränkt, sondern vielmehr in einer Abstufung der Dotierungstärke auch in den anderen Maskenbereichen zu einer geringeren Dotierungsstärke führt. Mit Hilfe einer entgegengesetzten Dotierung entlang einer anderen Implantationsrichtung parallel zu einer zweiten oder dritten Ausrichtung ist es auch möglich, diese geringere Dotierung überzukompensieren.

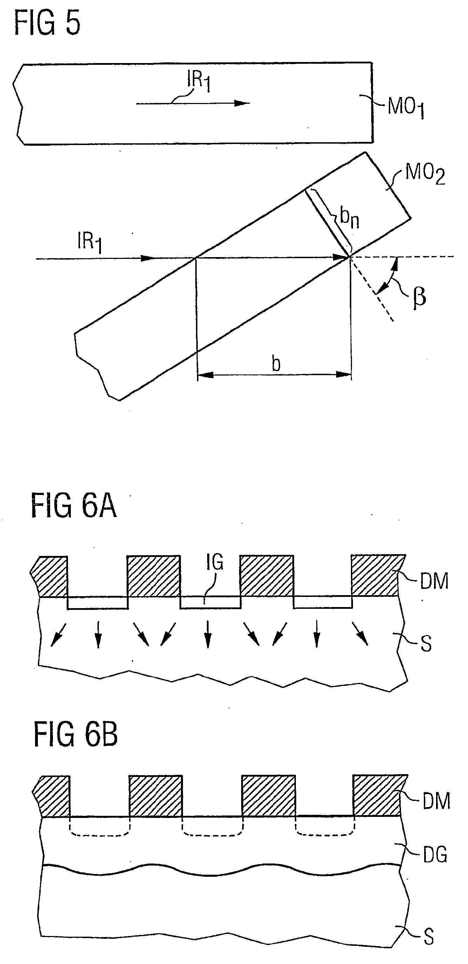

Figur 5 zeigt zwei nur in der Figur einander gegenübergestellte Maskenöffnungen MO1, MO2, die verschiedenen, üblicherweise voneinander beabstandeten Maskenbereichen angehören und gegeneinander bezüglich ihrer Aus-richtung einen Winkel $\beta$ einschließen. Wird eine erste Schrägimplantation parallel zur Implantationsrichtung IR1 entsprechend der Ausrichtung der ersten Maskenöffnung MO1 geführt, so trifft diese Implantation unter dem Winkel $\beta$ zur ihrer Ausrichtung auf die zweite Maskenöffnung MO2 des zweiten Maskenbereichs. Zur Berechnung der Abschattung in der zweiten Maskenöffnung M02 unter dieser Implantationsrichtung IR1 ist das entsprechende Profil der Maskenöffnung parallel zu dieser Implantationsrichtung zu betrachten. Ausgehend von einer minimalen Breite $b_n$ der zweiten Maskenöffnung MO2 ist in diesem Ersatzprofil (Profil entlang der Schrägimplantation) eine schräg projizierte Breite b zu betrachten, für die gilt:

$$b_n = b * \cos\beta \text{ bzw. } b = b_n / \cos\beta.$$

Für schräge Implantationsrichtungen ergibt sich folgende Formel zur Berechnung des Grenzwinkels für die totale Abschattung:

$$h * \tan\alpha \geq b_n / \cos\beta.$$

Um also eine Abschattung zu erzielen, muss bei gegebenem Implantationswinkel $\alpha$ die Höhe h größer gewählt werden, als es sich aus dieser Formel ergibt. Alternativ kann auch die Breite b der Maskenöffnung MO geringer gewählt werden, um sicher eine vollständige Abschattung bei gegebener Vertiefung $\beta$ zu erzielen.

Durch die Implantation werden in den entsprechenden Maskenbereichen bzw. in den Bereichen des Substrats, die unterhalb der Maskenöffnungen MO eines Maskenbereichs liegen, zunächst implantierte Gebiete IG erzeugt. Figur 6a zeigt diese anhand eines schematischen Querschnitts durch das Substrat. Die implantierten Gebiete sind relativ flach und räumlich voneinander getrennt unterhalb jeder Maskenöffnung des entsprechenden Maskenbereichs angeordnet. Es ist daher erforderlich, die Dotierung innerhalb der implantierten Gebiete IG tiefer einzutreiben und dabei die räumlich voneinander getrennten Gebiete miteinander zu vereinigen.

Das Eintreiben der implantierten Dotierstoffe kann nach jedem einzelnen Implantationsschritt durchgeführt werden. Möglich ist es jedoch auch, das Eintreiben für alle in unterschiedlichen Maskenbereichen mit unterschiedlichen Dotierungen gemeinsam durchzuführen. Der erste Fall ist jedoch bevorzugt, da in der Regel für unterschiedliche Dotierstoffe unterschiedliche Eintreibbedingungen und insbesondere ein unterschiedliches thermisches Budget erforderlich ist. So ist es möglich, Dotierungen, die unterschiedliche Diffusionsgeschwindigkeiten der Dotierstoffe aufweisen, durch eine entsprechende Verteilung des erforderlichen thermischen Budgets auf die beiden Eintreibschritte auszugleichen.

Figur 6b zeigt, wie sich die ursprünglich getrennten implantierten Gebiete IG nach den Eintreibbedingungen zu einem gemeinsamen homogenen dotierten Gebiet DG vereinigt haben, das bei entsprechender Eintreibtiefe eine homogene Front auf der Unterseite ausgebildet hat.

Bei der Einstellung der Eintreibbedingungen, zu denen auch eine Eintreibatmosphäre, ein Druck und ein Temperaturprogramm gehören, ist auch die Dotierstoffkonzentration zu berücksichtigen, die bei dem entsprechenden Implantationsschritt in den implantierten Gebieten IG erzeugt worden ist. In implantierten Gebieten mit höherer Dotierstoffkonzentration diffundieren die Dotierstoffe üblicherweise tiefer in das Substrat S hinein, sodass in Maskengebieten mit unterschiedlichen Dotierstoffkonzentrationen in den dort erzeugten implantierten Gebieten aufgrund dieser Tatsache unterschiedlich tief eingetriebene dotierte Gebiete DG erzeugt werden.

Das erfindungsgemäße Verfahren kann vorteilhaft zur Herstellung von isolierenden Wannen, so genannten PTUBs, NTUBs, PWELLs und NWELLs für Hochvolt-Bauelemente verwendet werden. Für diesen Anwendungszweck werden die Einbaubedingungen vorzugsweise so gewählt, dass der Dotierstoff bis zu einer Tiefe von ca. 10 $\mu$m in den Halbleiter (Substrat S) getrieben wird. In entsprechend unterschiedlich dotierten Gebieten können unterschiedliche Teile von Halbleiterbauelementen realisiert werden, insbesondere z. B. Transistoren für bipolare Hochvolt-Bauelemente in Silizium oder anderen Halbleitersubstraten.

Obwohl das Verfahren nur anhand weniger Ausführungsbeispiele dargestellt wurde, ist es selbstverständlich nicht auf diese beschränkt. Variationsmöglichkeiten ergeben sich insbesondere aus der genauen Ausformung der Maskenöffnungen, aus deren Anzahl, Größe und Verteilung sowie aus der Anordnung unterschiedlicher Maskenbereiche relativ zueinander. Die Maskenbereiche können sich außerdem in Größe und Form voneinander unterscheiden, innerhalb eines Maskenbereiches können auch Maskenöffnungen unterschiedlicher Länge angeordnet sein. Es ist auch möglich, die Maskenöffnungen der Länge nach in eine Reihe kürzerer Maskenöffnungen aufzuteilen, wobei die Aufteilung in parallelen Reihen unterschiedlich bzw. versetzt sein kann.

Weitere Abweichungen von den dargestellten Ausführungsbeispielen ergeben sich bezüglich Substrat und bei der Implantation eingebrachten Dotierstoff. Möglich ist es auch, in der Maske mehr als drei unterschiedliche Maskenbereiche zu realisieren. Möglich ist es auch, innerhalb der Maskenbereiche durch die genannte Ausrichtung Implantationen mit demselben Dotierstoff unter unterschiedlichen Implantationsrichtungen durchzuführen, wobei in den unterschiedlichen Maskenbereichen unterschiedlich starke Dotierungen mit dem gleichen Dotierstoff erzielt werden. Möglich ist es auch, dies mit den genannten unterschiedlichen Dotierungen bezüglich des Dotierstoffs zu kombinieren. Aus unterschiedlichen Raumrichtungen kann mit der gleichen Maske auch mit unterschiedlichen Implantationswinkeln implantiert werden.

Bezugszeichenliste

| | |
|---|---|
| S | Substrat |
| DM | Maske |
| MO1 | erste Maskenöffnung |
| IR1 | erste Implantationsrichtung |
| X | erste Ausrichtung |
| Y | zweite Ausrichtung |
| MB1 | erster Maskenbereich |
| MB2 | zweiter Maskenbereich |
| IG1 | erstes implantiertes Gebiet |
| IG2 | zweites implantiertes Gebiet |
| GW | Grenzwinkel |
| a | Abstand zweier Maskenöffnungen |
| b | Breite einer Maskenöffnung |
| h | Höhe der Maske |
| IR1 | erste Implantationsrichtung |
| N | Oberflächennormale über Substrat |
| t | Tiefe des Dotierungsgebiets |
| AG | Abgeschattetes Gebiet |
| $\alpha$ | Implantationswinkel |
| $\beta$ | Winkel zwischen ersten und zweiten Maskenöffnungen |

**Patentansprüche**

1.  Maske zum Erzeugen unterschiedlicher Dotierungen in einem Substrat,

    - die aus einer auf dem Substrat (S) angeordneten Maskenschicht (MS) mit einheitlicher Höhe (h) ausgebildet ist,
    - mit einem ersten Maskenbereich ($MB_1$) mit ersten Maskenöffnungen ($MO_1$), die langgestreckt ausgebildet und parallel zu einer ersten Ausrichtung (x) ausgerichtet sind,
    - mit einem zweiten Maskenbereich ($MB_2$) mit zweiten Maskenöffnungen ($MO_2$), die langgestreckt ausgebildet und parallel zu einer zweiten Ausrichtung (y) ausgerichtet sind, und
    - mit einem dritten Maskenbereich ($MB_3$) mit dritten Maskenöffnungen ($MO_3$), die langgestreckt ausgebildet und parallel zu einer dritten Ausrichtung (z) ausgerichtet sind,
    - **dadurch gekennzeichnet, dass** die erste Ausrichtung und die dritte Ausrichtung, die erste Ausrichtung und die zweite Ausrichtung sowie die zweite Ausrichtung und die dritte Ausrichtung jeweils einen Winkel 0° < β1, β2, β3 < 90° einschließen.

2.  Maske nach Anspruch 1, bei der
    die erste Ausrichtung (x) und die zweite Ausrichtung (y), die erste Ausrichtung (x) und die dritte Ausrichtung (z) sowie die zweite Ausrichtung (y) und die dritte Ausrichtung (z) jeweils einen Winkel ($\beta_1$, $\beta_2$, $\beta_3$) von 60° einschließen.

**3.** Maske nach Anspruch 1 oder 2,
ausgebildet als Hartmaske aus Oxid oder Nitrid.

**4.** Maske nach einem der Ansprüche 1 bis 3, bei der für zumindest eine Maskenöffnung (MO) gilt, dass die Breite (b) der Maskenöffnung kleiner als die Höhe (h) der Maskenschicht (MS) ist.

**5.** Maske nach einem der Ansprüche 1 bis 4, bei der jeder Maskenbereich ($MB_1$,$MB_2$,$MB_3$) eine Mehrzahl gleicher, im jeweils gleichen Abstand parallel zueinander angeordneter Maskenöffnungen ($MO_1$,$MO_2$,$MO_3$) umfasst.

**6.** Maske nach einem der Ansprüche 1 bis 5, bei der die Maskenöffnungen ($MO_1$,$MO_2$,$MO_3$) die Form langgestreckter Rechtecke aufweisen.

**7.** Maske nach einem der Ansprüche 1 bis 6, bei der Breite (b) und Abstand (a) der Maskenöffnungen ($MO_1$,$MO_2$,$MO_3$) innerhalb eines Maskenbereichs ($MB_1$,$MB_2$,$MB_3$) gleich sind.

**8.** Maske nach einem der Ansprüche 1 bis 7, bei der Breite (b) und/oder Abstand (a) der Maskenöffnungen ($MO_1$) des ersten Maskenbereichs ($MB_1$) verschieden sind von den Maskenöffnungen ($MO_2$) des zweiten Maskenbereichs ($MB_2$).

**9.** Verfahren zur Herstellung unterschiedlicher Dotierungsgebiete in einem Substrat, bei dem

- auf dem Substrat (S) eine Maske (DM) erzeugt wird mit einem ersten Maskenbereich ($MB_1$) mit ersten Maskenöffnungen ($MO_1$), die langgestreckt ausgebildet und parallel zu einer ersten Ausrichtung (x) ausgerichtet sind, einem zweiten Maskenbereich ($MB_2$) mit zweiten Maskenöffnungen ($MO_2$), die langgestreckt ausgebildet und parallel zu einer zweiten Ausrichtung (y) ausgerichtet sind, sowie einem dritten Maskenbereich ($MB_3$) mit dritten Maskenöffnungen ($MO_3$), die langgestreckt ausgebildet und parallel zu einer dritten Ausrichtung (z) ausgerichtet sind, , und
- Implantationen von Dotierstoff aus verschiedenen Richtungen durchgeführt werden, wobei ein gegen eine Oberflächennormale des Substrats gemessener Implantationswinkel ($\alpha$) jeweils zwischen 0° und 90° liegt, wobei die Maskenöffnungen, parallel zur Projektion der Implantationsrichtung in die Substratebene ausgerichtet sind,
dadurch charakterisiert, dass
jeweils zwei der Ausrichtungen einen Winkel $0° < \beta_1, \beta_2, \beta_3 < 90°$ einschließen.

**10.** Verfahren nach Anspruch 9, bei dem
drei unterschiedliche Implantationen aus verschiedenen Richtungen durchgeführt werden.

**11.** Verfahren nach Anspruch 9 oder 10, bei dem
Implantationen unterschiedlicher Dotierstoffe durchgeführt werden.

**12.** Verfahren nach einem der Ansprüche 9 bis 11, bei dem
Implantationen unterschiedlicher Dotierstoffkonzentrationen durchgeführt werden.

**Claims**

**1.** Mask for generating different dopings in a substrate,

- which is formed by a mask layer (MS) having a uniform height (h) arranged on the substrate (S),
- with a first mask region ($MB_1$) having first mask openings ($MO_1$), which are configured elongated and oriented parallel to a first orientation (x),
- with a second mask region ($MB_2$) having second mask openings ($MO_2$), which are configured elongated and oriented parallel to a second orientation (y), and
- with a third mask region ($MB_3$) having third mask openings ($MO_3$), which are configured elongated and oriented parallel to a third orientation (z),
**characterized in that**
- the first orientation and the third orientation,the first orientation and the second orientation as well as the second orientation and the third orientation in each case include an angle $0° < \beta_1, \beta_2, \beta_3 < 90°$.

**2.** Mask according to claim 1, in which
the first orientation (x) and the second orientation (y), the first orientation (x) and the third orientation (z) as well as the second orientation (y) and the third orientation (z) in each case include an angle ($\beta_1$, $\beta_2$, $\beta_3$) of 60°.

**3.** Mask according to claim 1 or 2,
formed as a hard mask made of oxide or nitride.

**4.** Mask according to one of the claims 1 to 3, in which
it is true for at least one mask opening (MO) that the width (b) of the mask opening is smaller than the height (h) of the mask layer (MS).

**5.** Mask according to one of the claims 1 to 4, in which each mask region ($MB_1$, $MB_2$, $MB_3$) comprises a plurality of equal mask openings ($MO_1$, MO2, $MO_3$) arranged in each case at the same distance parallel to one another.

**6.** Mask according to one of the claims 1 to 5, in which the mask openings ($MO_1$, MO2, $MO_3$) have the shape of elongated rectangles.

**7.** Mask according to one of the claims 1 to 6, in which width (b) and distance (a) of the mask openings ($MO_1$, MO2, $MO_3$) are equal within one mask region ($MB_1$, $MB_2$, $MB_3$).

**8.** Mask according to one of the claims 1 to 7, in which width (b) and/or distance (a) of the mask openings ($MO_1$) of the first mask region ($MB_1$) are different from the mask openings ($MO_2$) of the second mask region ($MB_2$).

**9.** Method for producing different doping regions in a substrate, in which

- a mask (DM) is generated on the substrate (S), the mask having a first mask region ($MB_1$) with first mask openings ($MO_1$), which are configured elongated and oriented parallel to a first orientation (x), a second mask region ($MB_2$) with second mask openings ($MO_2$), which are configured elongated and oriented parallel to a second orientation (y), as well as a third mask region ($MB_3$) with third mask openings ($MO_3$), which are configured elongated and oriented parallel to a third orientation (z), and
- implantations of dopants are performed from different directions, wherein an implantation angle ($\alpha$) measured against a surface normal of the substrate is in each case between 0° and 90°, wherein the mask openings are oriented parallel to the projection of the implantation direction into the substrate plane,
**characterized in that**
- in each case two of the orientations include an angle 0° < $\beta_1$, $\beta_2$, $\beta_3$ < 90°.

**10.** Method according to claim 9, in which
three different implantations are performed from different directions.

**11.** Method according to claim 9 or 10, in which
implantations of different dopants are performed.

**12.** Method according to one of the claims 9 to 11, in which
implantations of different dopant concentrations are performed.

**Revendications**

**1.** Masque destiné à produire différents dopages dans un substrat,

- lequel masque se compose d'une couche de masque (MS) agencée sur le substrat (S) présentant une hauteur (h) unique,
- avec un premier domaine de masque ($MB_1$) présentant des premières ouvertures de masque ($MO_1$) qui sont formées de manière longitudinale et sont alignées parallèlement à une première orientation (x),
- avec un deuxième domaine de masque ($MB_2$) présentant des deuxièmes ouvertures de masque ($M0_2$) qui sont formées de manière longitudinale et sont alignées parallèlement à une deuxième orientation (y) et
- avec un troisième domaine de masque ($MB_3$) présentant des troisièmes ouvertures de masque ($M0_3$) qui sont formées de manière longitudinale et sont alignées parallèlement à une troisième orientation (z),

**caractérisé en ce que**

- la première et la troisième orientation, la première et la deuxième orientation ainsi que la deuxième et la troisième orientation comprennent à chaque fois un angle 0° < $\beta_1$, $\beta_2$, $\beta_3$ < 90°.

2. Masque selon la revendication 1, dans lequel
la première (x) et la deuxième (y) orientation, la première (x) et la troisième (z) orientation ainsi que la deuxième (y) et la troisième (z) orientation comprennent à chaque fois un angle ($\beta_1$, $\beta_2$, $\beta_3$) de 60°.

3. Masque selon la revendication 1 ou 2,
formé comme un masque dur en oxyde ou nitrure.

4. Masque selon l'une quelconque des revendications 1 à 3, dans lequel le fait que la largeur (b) de l'ouverture du masque est inférieure à la hauteur (h) de la couche du masque (MS) vaut pour au moins une ouverture de masque (MO).

5. Masque selon l'une quelconque des revendications 1 à 4, dans lequel chaque domaine de masque ($MB_1$, $MB_2$, $MB_3$) comprend une pluralité d'ouvertures de masque ($M0_1$, M02, $M0_3$) identiques agencées parallèlement les unes aux autres à égale distance.

6. Masque selon l'une quelconque des revendications 1 à 5, dans lequel les ouvertures de masque ($M0_1$, $M0_2$, $M0_3$) présentent la forme de rectangles allongés.

7. Masque selon l'une quelconque des revendications 1 à 6, dans lequel la largeur (b) et la distance (a) des ouvertures de masque ($M0_1$, M02, $M0_3$) sont identiques au sein d'un domaine de masque ($MB_1$, $MB_2$, $MB_3$).

8. Masque selon l'une quelconque des revendications 1 à 7, dans lequel la largeur (b) et/ou la distance (a) des ouvertures de masque ($M0_1$) du premier domaine de masque ($MB_1$) sont différentes des ouvertures de masque ($M0_2$) du deuxième domaine de masque ($MB_2$).

9. Procédé destiné à la fabrication de différentes zones de dopage dans un substrat dans lequel

- un masque (DM) est produit sur le substrat (S) avec un premier domaine de masque ($MB_1$) présentant des premières ouvertures de masque ($M0_1$) qui sont formées de manière longitudinale et sont alignées parallèlement à une première orientation (x), un deuxième domaine de masque ($MB_2$) présentant des deuxièmes ouvertures de masque ($M0_2$) qui sont formées de manière longitudinale et sont alignées parallèlement à une deuxième orientation (y) ainsi qu'un troisième domaine de masque ($MB_3$) présentant des troisièmes ouvertures de masque ($M0_3$) qui sont formées de manière longitudinale et sont alignées parallèlement à une troisième orientation (z), et
- des implantations de substances de dopage sont réalisées à partir de différentes directions, un angle d'implantation ($\alpha$) mesuré en fonction d'une normale de surface du substrat se situant dans une plage comprise entre 0° et 90°, les ouvertures de masque étant orientées parallèlement à la projection de la direction d'implantation dans le plan du substrat,
**caractérisé en ce que**
- deux des orientations comprennent à chaque fois un angle 0° < $\beta_1$, $\beta_2$, $\beta_3$ < 90°.

10. Procédé selon la revendication 9, dans lequel trois implantations différentes sont réalisées à partir de directions différentes.

11. Procédé selon la revendication 9 ou 10, dans lequel des implantations de différentes substances de dopage sont réalisées.

12. Procédé selon l'une quelconque des revendications 9 à 11, dans lequel des implantations de différentes concentrations de substances de dopage sont réalisées.

## FIG 1A

## FIG 1B

FIG 2A

MB$_1$

MB$_2$

IR$_1$

MO$_1$

x

β

A

B

MO$_2$

IR$_2$

y

FIG 2B

y

IR$_2$

MO$_2$

DM

MO$_1$

IG$_2$

S

FIG 3

FIG 4

FIG 5

IR$_1$

MO$_1$

MO$_2$

$b_n$

IR$_1$

$\beta$

$b$

FIG 6A

IG

DM

S

FIG 6B

DM

DG

S

**IN DER BESCHREIBUNG AUFGEFÜHRTE DOKUMENTE**

**In der Beschreibung aufgeführte Patentdokumente**

- US 5300545 A
- US 5512498 A
- JP 9055438 A
- JP 2000228496 A
- JP 09063983 A
- US 4648174 A